**Europäisches Patentamt**

(19) **European Patent Office**

**Office européen des brevets**

(11) Publication number : **0 417 747 B1**

(12) # EUROPEAN PATENT SPECIFICATION

(45) Date of publication of patent specification :
01.03.95 Bulletin 95/09

(51) Int. Cl.⁶ : **H01L 25/11, H01L 25/07**

(21) Application number : **90117523.2**

(22) Date of filing : **11.09.90**

(54) **Module-type semiconductor device of high power capacity.**

(30) Priority : **11.09.89 JP 235240/89**

(43) Date of publication of application :
**20.03.91 Bulletin 91/12**

(45) Publication of the grant of the patent :
**01.03.95 Bulletin 95/09**

(84) Designated Contracting States :
**DE FR GB**

(56) References cited :
**EP-A- 0 145 256**
**EP-A- 0 277 546**
**EP-A- 0 292 848**
**DE-A- 2 718 967**
**FR-A- 2 535 898**

(56) References cited :
**CONFERENCE RECORD OF THE 1989 IEEE INDUSTRY APPLICATIONS SOCIETY ANNUAL MEETING, PART II, CH-2792-0/89/0000-1352, San Diego, California, 1st-5th October 1989, pages 1352-1355, IEEE, New York, US; M. MOROZOWICH: "300 Ampere, 1000 volt hermetic darlington transistor"**
**Patent Abstracts of Japan, vol. 13, no. 486(E-840) & JP-A-1194344**

(73) Proprietor : **KABUSHIKI KAISHA TOSHIBA**
**72, Horikawa-cho**
**Saiwai-ku**
**Kawasaki-shi (JP)**

(72) Inventor : **Hideshima, Makoto, c/o Intellectual Property Div.**
**Kabushiki Kaisha Toshiba,**
**1-1 Shibaura 1-chome**
**Minato-ku, Tokyo (JP)**

(74) Representative : **Lehn, Werner, Dipl.-Ing. et al**
**Hoffmann, Eitle & Partner,**
**Patentanwälte,**
**Postfach 81 04 20**
**D-81904 München (DE)**

## Description

This invention relates to a module type semiconductor device of high power capacity.

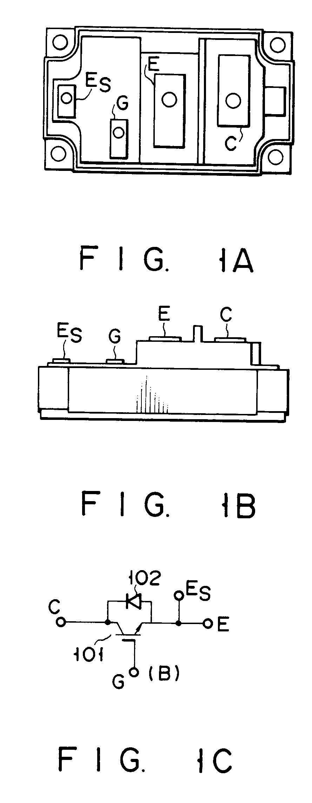

IGBTs, representative of high speed and high power switching elements, have heretofore been formed of module casings having a structure shown in Figs. 1A and 1B. Fig. 1C shows an equivalent circuit of the IGBT.

In Figs. 1A and 1B, a collector C and an emitter E forming main current terminals, and a gate G and an emitter Es forming input terminals for drive signals are used as corresponding, respectively, to collect C and an emitter E forming main current terminals in a bipolar transistor 101 shown in Fig. 1C, and a base B and an emitter Es forming signal input terminals of same. Between the collector and the emitter is interposed a portion that functions similar to a diode, and hence a diode 102 is incorporated therebetween.

Within the module casing shown in Figs. 1A and 1B are incorporated a plurality of, usually four, IGBT chips for being driven in parallel, thereby completing a high current semiconductor switching module.

The foregoing arrangement is disclosed in a publication entitled "1000V 300A Bipolar-Mode MOS FET (IGBT) Module", 1988 Proc. of ISPSD, pp 80-85, M. Hidesima, et al.

In some applications, a plurality of module type semiconductor devices of high power capacity of the arrangement shown in Figs. 1A and 1B are connected in parallel to each other to obtain a circuit, such as an inverter, of further increased power capacity. In this case, it may be proposed to provide an ultra high power semiconductor device without connecting a plurality of modules but sealing several of modules in a single module casing. This, however, is not preferred on the following grounds.

First, the range of general applications of the module type semiconductor device becomes limited. Second, the number of parallel connections of IGBT chips within the module type semiconductor device become too excessive that the productivity of the device is decreased. Third, with an increase in a value of the current managed by a single module, wiring requirements within the device increase. Accordingly, use of module type semiconductor devices in parallel connections each having IGBT chips sealed within the casing in a convenient number of four is believed to be economical in high power capacity applications.

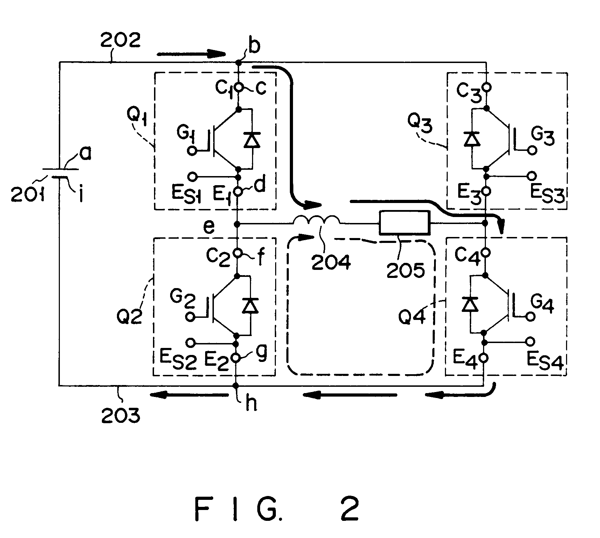

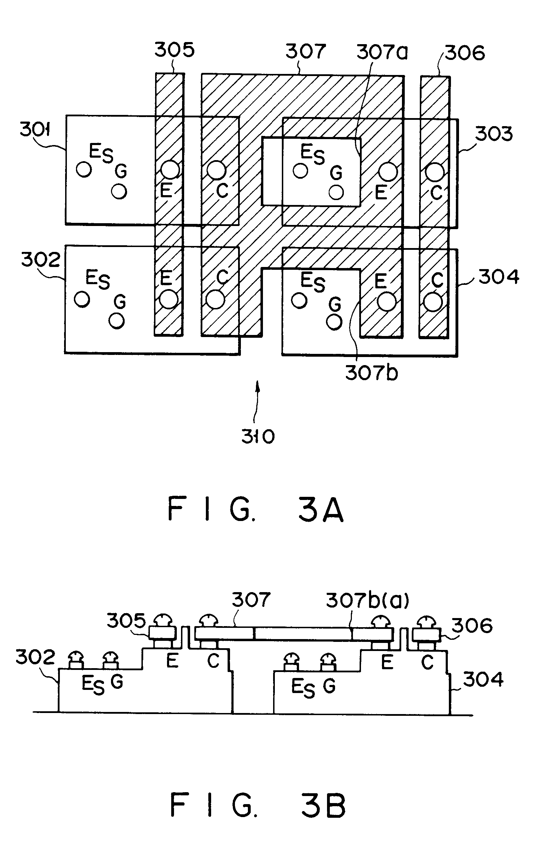

Fig. 2 is a circuit diagram showing the arrangement of a bridge-type chopper circuit using the module type semiconductor device of high capacity. Equivalent circuits Q1 to Q4 representing the IGBTs and each formed of a module type semiconductor device fabricated with a conventional module package shown in Figs. 1A and 1B are connected two by two in parallel to obtain a high capacity. A half bridge structure showing the interconnections of the equivalent circuits Q1 and Q2 in Fig. 2 is illustrated in Fig. 3A. As shown, the module type semiconductor devices 301 and 302 are connected in parallel to form the equivalent circuit Q2, and the module type semiconductor devices 303 and 304 having equivalent properties as the devices 301 and 302 are connected in parallel to form the equivalent circuit Q1. A bus bar 305 connects main current terminals of the respective emitters of the module type semiconductor devices 301 and 302, and a bus bar 306 connects main current terminals of the respective collectors of the module type semiconductor devices 303 and 304. Further, a bus bar 307 makes interconnections between the collector main current terminals of the module type semiconductor devices 301 and 302, between the emitter main current terminals of the module type semiconductor devices 303 and 304, and between the module type semiconductor devices 301 and 302, and 303 and 304. The structure as viewed from an arrow 310 in Fig. 3A is shown in Fig. 3B.

As shown in Figs. 3A and 3B, it is necessary to form openings 307a and 307b in the bus bar 307 at locations above signal input terminals Es and G of the module type semiconductor devices 303 and 304 to enable wiring connections to the signal terminals.

It has been found that, when the module type semiconductor devices fabricated with the module casing as shown in Figs. 1A and 1B are subjected to bus bar wiring as shown in Figs. 3A and 3B, a problem occurs that as the proposed current capacity of the module type semiconductor device increases and the proposed speed of switching operation increases, an inductance component of commutating circuits which increases surge voltage becomes not negligible, requiring setting a large margin for the voltage withstandability of the circuit elements.

Moving to Fig. 2, the mechanism of commutating operation and the generation of surge voltage will be explained. The circuit shown is a so-called bridge circuit in which the IGBTs Q1 and Q2 are connected in series between a bus 202 and a bus 203 leading from a DC power supply 201, the IGBTs Q3 and Q4 are similarly connected in series therebetween, and an electric reactor 204 and a resistor 205 are connected between connecting points midway between the respective series connection lines.

Assume now that the IGBTs Q1 and Q4 are on and current is flowing through the circuit shown by arrows in solid lines. If the IGBT Q1 is turned off, a load current commutates through the circuit shown by an arrow in a dotted line. At this time, inductance L of the circuit and the rate of change of current di/dt generate a counter electromotive force of -L(di/dt) as surge voltage, which is impressed across the IGBT Q1 which has been turned off.

The inductance L here is affected by an inductance component of the bus 202 between nodes a and b, an inductance component of the bus 203 between nodes h and i, inductance components of the wiring between nodes b and c and between d and e, and by inductance components of the wiring between nodes e and f and between g and h.

If, for example, the inductance L is 0.2 μH and an IGBT with a current of 400A is turned off at time intervals of 0.3 μs, the following equation holds.

$$V = L(di/dt) = 0.2 \times (10 - 6 \times 400) / (0.3 \times 10 - 6) \simeq 270\ V \quad (1)$$

Equation (1) suggests the production of a surge voltage of approximately 270V. To use an IGBT element at 500 V in the circuit arrangement shown in Fig. 2, it is necessary to use the voltage of the power supply at 230 V or below, so that use of IGBTs becomes limitative.

Where a module type semiconductor device of a package of the structure shown in Figs. 1A and 1B is used, what has been done in an attempt to decrease inductance components as far as possible is to permit the collector C of the module forming Q1 and the emitter E of the module forming Q2 to be connected by a cupper plate and to punch out the cupper plate at portions of the terminals G and Es. This has resulted in lengthy wiring and limited surface area of the copper plate and hence in an increase in commutating inductance. With increasing demand on still higher speed operation of module type semiconductor devices, a decrease in the commutating inductance has been sought.

From Patent Abstract of Japan 13 (486), (E-840) a parallel connection of power transistors is known, wherein collectors and emitters of respective transistors are connected to pairs of conductors arranged closely to each other, while the terminals of the same type are connected in common, in order to minimize line inductances and facilitate effective utilization of the current capacities of the transistors. All emitter terminals of an upper arm and the respective collector terminals of a lower arm are connected to one conductor plate in common and further the conductor plate is connected to an arm part of L-shape to provide connection to respective modules. A double-L-shaped multileg arm conductor is used for connecting the other terminals of the power transistors.

Accordingly, an object of the invention is to provide a module type semiconductor device having a shortened length of interconnection wiring, a large surface area of the wiring and a bridge connection structure capable of canceling magnetic flux to be generated by commutating current, with a view to minimizing commutating inductance.

According to the present invention this object is solved by a module type semiconductor device of a high power capacity comprising:
first and second casings;
first and second power semiconductor devices having equivalent electrical properties sealed respectively within said first and second casings; and

external terminals formed of main current input terminals, main current output terminals and signal input terminals of said power semiconductor devices provided on a top surface of each of said first and second casings;
said external terminals of said first casing having a terminal arrangement in which the signal input terminals are located on an opposite side of the main current output terminal with respect to said current input terminal, and the external terminals of said second casing having a terminal arrangement in which the signal input terminals are located on an opposite side of the main current input terminal with respect to the main current output terminal, whereby said first and second casings are formed on a plane in a pair such that the main current input terminal of said first casing and the main current output terminal of said second casing are in close proximity to and oppose each other, and which further comprises:
a first bus bar electrically interconnecting said opposing current input terminal and current output terminal.

Furthermore, according to the present invention this object is solved by a module type semiconductor device of a high power capacity comprising:
first and second casings each having a projecting central portion on a top surface thereof whose surface is plane, said projecting central portion being adjoined on opposing sides by two planes of said top surface at a lower level than said central portion, said first and second casings each comprising at least one pair of semiconductor chips for forming a power semiconductor device sealed therein; each casing comprising a main current input terminal and a main current output terminal formed on the projecting central portion thereof; and
two pairs of internally connected signal input terminals, each pair being located on one of the lower planes positioned on both sides of the projecting central portion,
one of said pairs of signal input terminals of said first casing opposes one of said pairs of signal input terminals of said second casing, such that one of said main current input terminals of one of said first and second casings opposes one of said main current output terminals of the other one of said first and second casings, and which further comprises:
a first bus bar electrically interconnecting said opposing current input terminal and current output terminal.

According to a first embodiment of the invention, a pair of high power module type semiconductor devices are provided which comprise first and second casings of a substantially equivalent type; power semiconductor devices of substantially equivalent electrical properties sealed respectively within the first and second casings; and external terminals formed of current input terminals, current output terminals and signal input terminals of the power semiconductor devices, which are taken externally of the first and second casings from top thereof; the external terminals taken externally of the first casing having a terminal arrangement in which the signal input terminals are located on an opposite side of the current output terminal with respect to the current input terminal, and the external terminals taken externally of the second casing having a terminal arrangement in which the signal input terminals are located on an opposite side of the current input terminal with respect to the current output terminal.

Where the first casing and the second casing are bridge connected by a bus bar with the above mentioned arrangement, distances of connections between elements may be shortended to a minimum. Since signal input terminals may be located outside the bus bar, openings for exposure of signal input terminals need not be formed in the bus bar structure, so that the overall structure is simplified to make effective use of a surface area of the bus bar, with the result that a decrease in commutating inductance is achieved.

A second embodiment of the invention provides a module type semiconductor device of high power capacity which comprises a having a projecting central portion whose top is plane casing sealing therein at least one pair of semiconductor chips for forming a power semiconductor device and having two different planes; a current input terminal and a current output terminal taken externally of the casing at the projecting central portion thereof and from one of the planes higher than the other plane of the power semiconductor device; and

two pairs of equivalent signal input terminals located on a lower plane positioned on both sides of the central higher plane and connected in common with the casing.

Similar effects as in the first embodiment may be obtained by fabricating a structure using the above module type semiconductor device in a pair. The device according to this embodiment is suitable for mass production since there is only a single layout for terminals that are taken out of the casing.

This invention can be more fully understood from the following detailed description when taken in conjunction with the accompanying drawings, in which:

Fig. 1A is a plan view illustrating the outer appearance of a conventional module casing for a module type semiconductor device (IGBT);

Fig. 1B is a side view of the structure shown in Fig. 1A;

Fig. 1C is an equivalent circuit of the IGBT;

Fig. 2 is a circuit diagram showing the structure of an application circuit to which this invention relates;

Fig. 3A is a plan view showing the form of mounting of mutually connected module type semiconductor devices (IGBTs) of a known type;

Fig. 3B is an outside view of the structure shown in Fig. 3A as viewed from the side;

Fig. 4A is a plan view showing the appearance of a module package of one of a pair of module type semiconductor devices according to the first embodiment of the invention;

Fig. 4B is a view similar to Fig. 4A showing the appearance of a module casing of the other of the pair of module type semiconductor devices according to the first embodiment of the invention;

Fig. 4C is a side view of the structure shown in Fig. 4A;

Fig. 4D is a side view of the structure shown in Fig. 4B;

Fig. 5 is a perspective view showing the inside structure of the module type semiconductor devices according to this invention;

Fig. 6A is a plan view showing the form of mounting of mutually connected module type semiconductor devices (IGBTs) according to the first embodiment of the invention;

Fig. 6B is a view showing the appearance of the structure of Fig. 6A as viewed from the side;

Fig. 7A is a plan illustrating the appearance of a module package of module type semiconductor devices according to the second embodiment of the invention;

Fig. 7B is a side view of the structure shown in Fig. 7A; and

Fig. 8 is a view showing the form of mounting of mutually connected module type semiconductor devices (IGBTs) as viewed from the side, in accordance with the second embodiment of the invention.

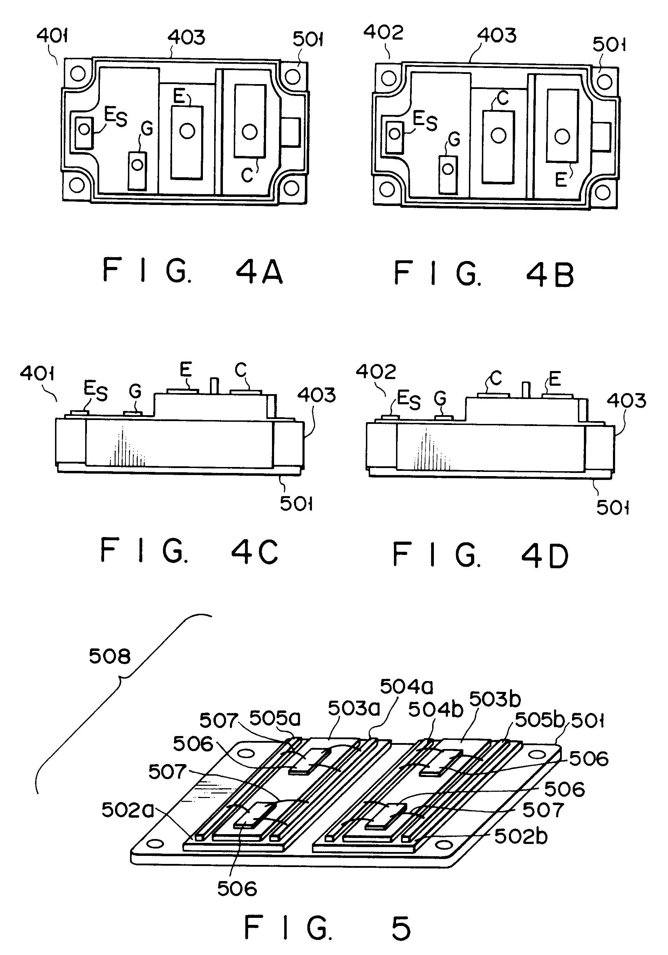

The embodiments of the invention will be described with reference to the accompanying drawings. Figs. 4A, 4B, 4C and 4D show the appearance of module type semiconductor devices according to the first embodiment. It is a feature that a pair of module type semiconductor devices 401 and 402 form a set.

In particular, the arrangement of terminals of the module type semiconductor device 401 forming an IGBT is in the order of signal input terminals Es and G, and an emitter E and a collector C forming main current external terminals. In contrast, in the module type semiconductor device 402, the order of the emitter E and the collector C is opposite, and they are in the order of signal input terminals Es and G, the collector C and the emitter E forming the main current external terminals.

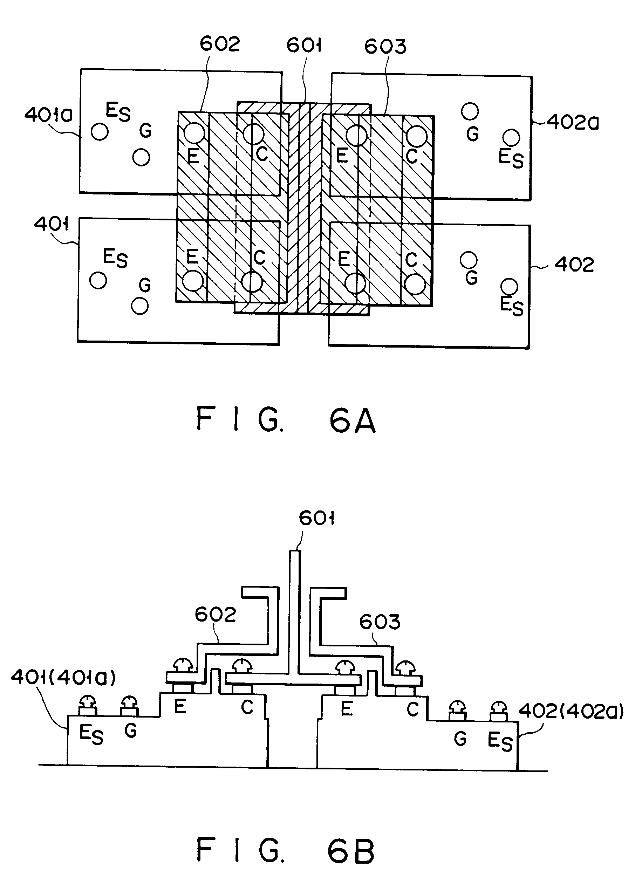

A pair of the module type semiconductor devices 401 and 402 are structured with equivalent electrical properties, and their inside structures are as shown in Fig. 5. In the figure, two insulating substrates 502a and 502b of an identical nature are soldered on a heat radiation substrate 501. On the insulating substrate 502a are fixed a metal plate 503a and relaying metal plates 504a and 505a on both sides of the metal plate 503a. Likewise, on the insulating substrate 502b are fixed a metal plate 503b and relaying metal places 504b and 505b on both sides of the metal plate 503b. Identical semiconductor chips 506 are mounted two by two on each of the metal plates 503a and 503b.

Wiring of electrodes on the semiconductor chips 506, here an emitter and a gate, is effected such that the emitter is connected to the metal plates 504a and 504b by metal wiring lines 507, and the gate is connected to the metal plates 505a and 505b by metal wiring lines 507. A power semiconductor device 508 is thus structured.

While not illustrated, a metal lead acting as an external terminal common to the two relaying metal plates 504a and 504b is soldered to form a main current external terminal of the emitter. Further, a metal lead acting as an external terminal common to the two relaying metal plates 503a and 503b is soldered to constitute a signal input external terminal of the gate. A metal lead acting as an external terminal common to the two relaying metal plates 504a and 504b is soldered to form a signal input external terminal of the emitter.

These external terminals are fabricated to have a terminal structure shown in the module type semiconductor device 401 or 402 of Figs. 4A and 4B. For example, in forming main current external terminals of the emitter and the collector, two kinds of external terminal metal lead may be used so that the positioning of the main current terminals of the collectors and the emitters which are externally taken out of the semiconductor devices is mutually opposite.

Instead of connecting the relaying metal plates 504a and 505a, or 504b and 505b to the external terminals, the plates themselves may be externally taken out as external terminals.

As a result of this, a pair of module type semiconductor devices 401 and 402 having the terminal arrangement as shown in Figs. 4A, 4B, 4C and 4D are constituted. A resin casing 403 is bonded on the heat radiation substrate 501 shown in Fig. 5. The resin casing 403 is resin sealed to protect the semiconductor chips and the other component elements shown in Fig. 5.

A pair of the module type semiconductor devices 401 and 402 may form a half bridge circuit as shown in Figs. 6A and 6B by employing another set of a pair of the devices designated by reference numerals 401a and 402a. Wiring interconnections of elements as those of Q1 and Q2 in the circuit arrangement of Fig. 2 are as follows.

The collector terminals C of the semiconductor device 401 and 401a and the emitter terminals E of the devices 402 and 402a are interconnected by a bus bar 601 and externally taken out as an output electrode. A positive electrode of the DC power supply (bus 202 side in Fig. 2) is connected to a bus bar 602, and a negative electrode (bus 203 side in Fig. 2) to a bus bar 603. The bus bars 602 and 603 are disposed in as parallel as possible to and in as close as possible proximity to the bus bar 601. The bus bar 602 is connected to the emitter terminals E of the semiconductor devices 401 and 401a, and the bus bar 603 is connected to the collector terminals C of the semiconductor devices 402 and 402a.

As has been described, the module type semiconductor devices in pairs shown in Figs. 4A to 4D and 6A and 6B in accordance with the first embodiment are featured by the arrangement that, in one of a pair of the module type semiconductor devices, signal input terminals (corresponding to Es and G) are located on the other side of current output terminals (corresponding to the emitter terminals E) with respect to current input terminals (corresponding to the collector terminals C), and that, in the other of a pair of the module type semiconductor devices, signal input terminals are mounted on the other side of current input terminals with respect to current output terminals. The above construction produces the following functions and meritorious effects.

1. Pairs of module type semiconductor devices are easily fabricated using all of the components in common, except for the preparation of two kinds of external terminal metal leads for connection with the relaying metal plates. There are almost no differences in electrical properties between the pair of the semiconductor devices.

2. Distances of connections between elements in the case of bridge connections may be shortened to the minimum. Since the signal input terminals may be located outside the bus bars 601, 602 and 603, openings such as those 306a and 306b formed in the bus bar 306 in Fig. 3 A need not be formed. Space or the surface area of the bus bar thus may be effectively used.

3. The bus bars 602 and 603 leading to the electrodes on the side of the bus 202 and on the side of the bus 203 in the bridge circuit shown in Fig. 2 are capable of being projected upright in parallel to the bus bar 601 functioning as a connector electrode between elements, so that magnetic fluxes to be generated by the bus bars at turn-on times may be cancelled. The amount of commutating inductance may thus be kept minimum.

Item 3 above will be expanded with reference to Fig. 2. When current commutates as shown by an arrow in a dotted line upon turn-off of the IGBT Q1, which occurs subsequent to a stage in which the IGBTs Q1 and Q4 are turned on to allow current to flow as shown by arrows in solid lines, magnetic fluxes between the conductive busses between a and b and between h and i are canceled and inductance is minimum if the busses are wired in close proximity to each other. On the other hand, if the nodes between b-c and d-e of the IGBT Q1 are brought in close proximity to each other and wiring is effected to permit the direction of current flow is to be inverted, inductance therebetween is also minimum. Further, bringing the nodes between e-f and g-h in the IGBT Q2 in close proximity to each other to cancel magnetic fluxes, inductance therebetween is also brought to a minimum.

With the above arrangement, a bridge circuit, such as one shown in Fig. 2, may have bus bar wiring as shown in Figs. 6A and 6B, even if Q1 and Q4 are arranged by parallel connecting a plurality of module type semiconductor devices, regardless of the number of parallel interconnections. The inductance of the commutating circuit is thus made minimum. As a result, surge voltage at the time of commutation, to be generated upon turn-on and off of the IGBTs may be greatly decreased.

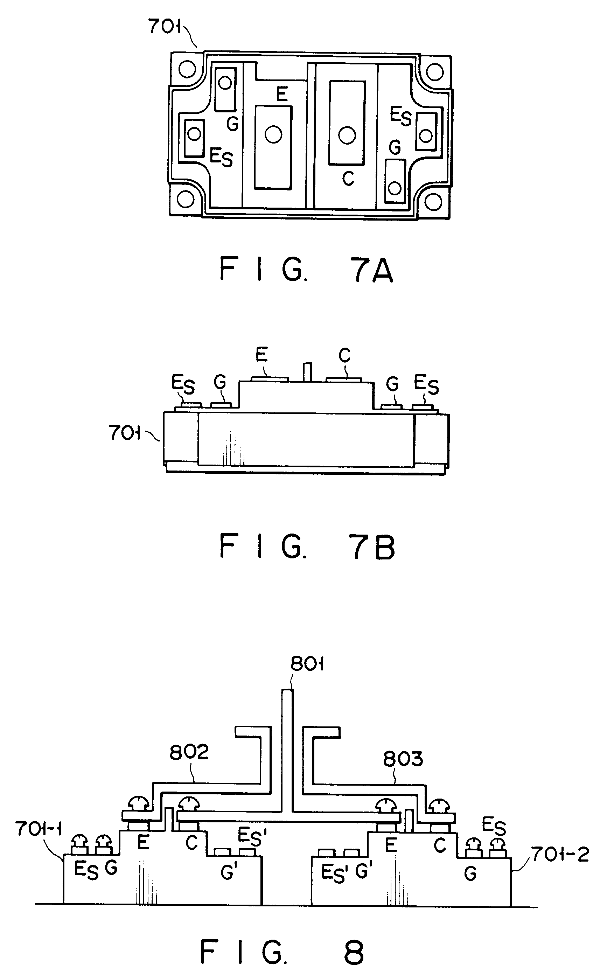

The second embodiment illustrated in Figs. 7A and 7B provides a novel package configuration for achieving the structure of a pair of the module type semiconductor devices shown in Figs. 4A to 4D by a single module type semiconductor device. A half bridge circuit in which the module type semiconductor devices according to the second embodiment are connected in parallel is shown in Fig. 8.

In Figs. 7A and 7B, on both sides of the collector C and the emitter E which are the main current terminals is mounted a pair of signal input terminals Es and G, which are interconnected to each other within the module. The input of signals can thus be effected using only one of the pair of the signal input terminals. A plane on which the signal input terminals Es and G are located is set lower than a plane on which the main current terminals E and C are positioned.

Two of the module-type semiconductor device 701, denoted by reference numerals 701-1 and 701-2, may be wired by bus bars 801, 802 and 803 as shown in Fig. 8. Terminals Es and G of the respective semiconductor devices 701-1 and 701-2 are used as signal input terminals and terminals Es' and G' located inwardly of the devices are not used, so that the inductance of the commutating circuit can be minimized similarly as in the first embodiment shown in Figs. 6A and 6B.

While the length of the bus bar 801 in Fig. 8 is slightly longer than the bus bar 601 in Fig. 6B, the increase of inductance is negligibly small inasmuch as the bus bar 801 may be positioned in parallel to and in close proximity to the bus bars 802 and 803.

In Figs. 7A and 7B, the non used signal input terminals Es' and G' are formed on a plane lower than that of the main current terminals E and C, so that the presence of the non used signal input terminals G' and Es' is not at all a bar to linearly connecting the collector C of the semiconductor device 701 and the emitter E of the semiconductor device 701a by the bus bar 801. In comparison with the first embodiment, this arrangement has an advantage in that the terminals that are taken out externally of the casing are in a single pattern or arrangement, so that the structure is suited for mass production.

In the foregoing embodiments, the signal input terminals Es and G have been described as an example of screw terminals, they may of course be in fastening terminals configuration, etc. Further, the IGBTs have been described as an example of the module type semiconductor device according to this invention, the invention is applicable also to usual MOS FETs, bipolar transistors, etc. Needless to say, the effects of the invention are most conspicuously displayed in IGBT speed switching function.

Reference signs in the claims are intended for better understanding and shall not limit the scope.

## Claims

1. A module type semiconductor device of a high power capacity comprising:

   first and second casings (401, 402);

   first and second power semiconductor devices (508) having equivalent electrical properties sealed respectively within said first and second casings (401, 402); and

   external terminals formed of main current input terminals (C), main current output terminals (E) and signal input terminals (G), Es) of said power semiconductor devices provided on a top surface of each of said first and second casings (401, 402);

   said external terminals of said first casing having a terminal arrangement in which the signal input terminals (G, Es) are located on an opposite side of the main current output terminal (E) with respect to said current input terminal (C), and the external terminals of said second casing having a terminal arrangement in which the signal input terminals (G, Es) are located on an opposite side of the main current input terminal (C) with respect to the main current output terminal (E), whereby said first and second casings (401, 401a, 402, 402a) are formed on a plane in a pair such that the main current input terminal (C) of said first casing (401, 401a) and the main current output terminal (E) of said second casing (402, 402a) are in close proximity to and oppose each other, and which further comprises:

   a first bus bar (601) electrically interconnecting said opposing current input terminal (C) and current output terminal (E).

2. The module type semiconductor device according to claim 1, characterized in that said first and second casings (401, 402) are formed respectively of a resin.

3. The module type semiconductor device according to claim 1, characterized in that said first and second power semiconductor devices (508) sealed within said first and second casings (401, 402) each comprise pairs of semiconductor chips (506) having substantially equivalent electrical properties.

4. The module type semiconductor device according to claim 3, characterized in that said semiconductor chips (506) have a layout for said power semiconductor devices, which is common both within said first and second casings (401, 402).

5. The module type semiconductor device according to claim 1, characterized in that said external terminals (E, C, G, Es) are screw terminals.

6. The module type semiconductor device according to claim 1, characterized in that said first bus bar is taken out externally upwardly as an electrode; and wherein

a second bus bar (602) located in as parallel as possible to and in as close as possible proximity to said first bus bar (601) on one side thereof and electrically connected to the current output terminal (E) of the power semiconductor device (508), which is taken externally of said first casing (401, 401a); and

a third bus bar (603) located in as parallel as possible to and in as close as possible proximity to said first bus bar (601) on the other side thereof and electrically connected to the current input terminal (C) of the power semiconductor device (508), which is taken externally of said second casing (402, 402a)

7. A module type semiconductor device of a high power capacity comprising:

first and second casings each having a projecting central portion on a top surface thereof whose surface is plane (701), said projecting central portion being adjoined on opposing sides by two planes of said top surface at a lower level than said central portion, said first and second casings each comprising at least one pair of semiconductor chips (506) for forming a power semiconductor device (508) sealed therein; each casing comprising a main current input terminal (C) and a main current output terminal (E) formed on the projecting central portion thereof; and

two pairs of internally connected signal input terminals, each pair (G, Es) being located on one of the lower planes positioned on both sides of the projecting central portion,

one of said pairs of signal input terminals (G, Es) of said first casing (701-1), 701-2) opposes one of said pairs of signal input terminals (G, Es) of said second casing, such that one of said main current input terminals of one of said first and second casings opposes one of said main current output terminals of the other one of said first and second casings, and which further comprises:

a first bus bar (801) electrically interconnecting said opposing current input terminal (C) and current output terminal (E).

8. The module type semiconductor device according to claim 7, characterized in that said casing (701) is formed of a resin.

9. The module type semiconductor device according to claim 7, characterized in that said semiconductor chips (506) forming the power semiconductor device (508) sealed within said casing are two or more and have equivalent electrical properties.

10. The module type semiconductor device according to claim 7, characterized in that the current input terminal (C), the current output terminal (E) and the two pairs of signal input terminals (G, Es) are, respectively, screw terminals.

11. The module type semiconductor device according to claim 7, characterized in that said first bus bar (801) is taken out externally upwardly as an electrode;

a second bus bar (802) is located parallel to and in close proximity to said first bus bar (801) on one side thereof and electrically connected to the main current output terminal (E) of said one (701-1) of said casings; and

a third bus bar (803) is located parallel to and in close proximity to said first bus bar (801) on the other side thereof and electrically connected to the current input terminal (C) of said other one (701-2) of said casings.

**Patentansprüche**

1. Halbleitervorrichtung hoher Leistungsfähigkeit vom Modultyp, mit
ersten und zweiten Gehäusen (401, 402);
ersten und zweiten Leistungshalbleitervorrichtungen (508), mit äquivalenten elektrischen Eigenschaften, jeweils in den ersten und zweiten Gehäusen (401, 402) eingeschlossen; und
externen Anschlüssen, die aus Hauptstromeingangsanschlüssen (C),
Hauptstromausgangsanschlüssen (E) und Signaleingangsanschlüssen (G, Es) der Leistungshalbleitervorrichtungen gebildet auf einer oberen Fläche eines jeden der ersten und zweiten Gehäuse (401, 402) vorgesehen sind;
wobei die externen Anschlüsse des ersten Gehäuses eine Anschlußanordnung aufweisen, in welcher die Signaleingangsanschlüsse (G, Es) auf einer gegenüberliegenden Seite des Hauptstromausgangsanschlusses (E) bezüglich des Stromeingangsanschlusses (C) angeordnet sind, und die externen Anschlüsse des zweiten Gehäuses eine Anschlußanordnung aufweisen, in welcher die Signaleingangsanschlüsse (G, Es) auf einer gegenüberliegenden Seite des Hauptstromeingangsanschlusses (C) bezüglich des Hauptstromausgangsanschlusses (E) angeordnet sind, wodurch die ersten und zweiten Gehäuse (401, 401a, 402, 402a) auf einer Ebene in einem Paar gebildet sind, so daß der Hauptstromeingangsanschluß (C) des ersten Gehäuses (401, 401a) und der Hauptstromausgangsanschluß (E) des zweiten Gehäuses (402, 402a) nahe beieinander und einander gegenüber angeordnet sind, und ferner mit einer ersten Busschiene (601), welche den gegenüberliegenden Stromeingangsanschluß (B) und Stromausgangsanschluß (E) elektrisch verbindet.

2. Halbleitervorrichtung vom Modultyp nach Anspruch 1, dadurch gekennzeichnet, daß die ersten und zweiten Gehäuse (401, 402) jeweils aus einem Harz gebildet sind.

3. Halbleitervorrichtung vom Modultyp nach Anspruch 1, dadurch gekennzeichnet, daß die in den ersten und zweiten Gehäusen (401, 402) eingeschlossenen ersten und zweiten Leistungshalbleitervorrichtungen (508) jeweils Paare von Halbleiterchips (506) mit im wesentlichen äquivalenten elektrischen Eigenschaften umfassen.

4. Halbleitervorrichtung vom Modultyp nach Anspruch 3, dadurch gekennzeichnet, daß die Halbleiterchips (506) ein Layout für die Leistungshalbleitervorrichtungen aufweisen, welches beiden in den ersten und zweiten Gehäusen (401, 402) gemeinsam ist.

5. Halbleitervorrichtung vom Modultyp nach Anspruch 1, dadurch gekennzeichnet, daß die externen Anschlüsse (E, C, G, Es) Schraubenanschlüsse sind.

6. Halbleitervorrichtung vom Modultyp nach Anspruch 1, dadurch gekennzeichnet, daß die erste Stromschiene aufwärts als eine Elektrode nach außen geführt wird; und worin eine zweite Busschiene (602) so parallel wie möglich und so nahe wie möglich an der ersten Schiene (601) an einer Seite davon angeordnet und elektrisch mit dem Stromausgangsanschluß (E) der Leistungshalbleitervorrichtung (508) verbunden ist, welcher aus dem ersten Gehäuse (401, 401a) nach außen geführt wird; und eine dritte Busschiene (603) so parallel wie möglich zu und so nahe wie möglich an der ersten Busschiene (601) auf der anderen Seite davon, und elektrisch mit dem Stromeingangsanschluß (C) der Leistungshalbleitervorrichtung (508) verbunden ist, welcher aus dem zweiten Gehäuse (402, 402a) nach außen geführt wird.

7. Halbleitervorrichtung hoher Leistungsfähigkeit vom Modultyp, mit ersten und zweiten Gehäusen, die jeweils einen vorstehenden zentralen Abschnitt auf einer oberen Fläche davon aufweisen, deren Oberfläche eben (701) ist, wobei der vorstehende mittlere Abschnitt auf gegenüberliegenden Seiten an zwei Ebenen der oberen Fläche auf einem niedrigeren Niveau als der mittlere Abschnitt angrenzt, wobei die ersten und zweiten Gehäuse jeweils wenigstens ein Paar von Halbleiterchips (506) zum Bilden einer darin eingeschlossenen Leistungshalbleitervorrichtung (508) umfassen; wobei jedes Gehäuse einen Hauptstromeingangsanschluß (C) und einen Hauptstromausgangsanschluß (E), gebildet auf dem vorstehenden mittleren Abschnitt davon, umfaßt; und zwei Paaren von intern verbundenen Signaleingangsanschlüssen, wobei jedes Paar (G, Es) auf einer der unteren Ebenen angeordnet ist, die auf den beiden Seiten des vorstehenden mittleren Abschnittes positioniert sind, eines der Paare von Signaleingangsanschlüssen (G, Es) des ersten Gehäuses (701-1, 701-2) ist einem der Paare von Signaleingangsanschlüssen (G, Es) des zweiten Gehäuses gegenüber angeordnet, so daß einer der Hauptstromeingangsanschlüsse von einem der ersten und zweiten Gehäuse einem der Hauptstromausgangsanschlüsse des anderen der ersten und zweiten Gehäuse gegenüber angeordnet ist, und ferner mit einer ersten Busschiene (801), die elektrisch den gegenüberliegenden Stromeingangsanschluß (C) und Stromausgangsanschluß (E) verbindet.

8. Halbleitervorrichtung vom Modultyp nach Anspruch 7, dadurch gekennzeichnet, daß das Gehäuse (701) aus einem Harz gebildet ist.

9. Halbleitervorrichtung vom Modultyp nach Anspruch 7, dadurch gekennzeichnet, daß die die Leistungshalbleitervorrichtung (508) bildenden Halbleiterchips (506), die in dem Gehäuse eingeschlossen sind, zwei oder mehr sind und äquivalente elektrische Eigenschaften haben.

10. Halbleitervorrichtung vom Modultyp nach Anspruch 7, dadurch gekennzeichnet, daß der Stromeingangsanschluß (C), der Stromausgangsanschluß (E) und die zwei Paare von Signaleingangsanschlüssen (G, Es) jeweils Schraubenanschlüsse sind.

11. Halbleitervorrichtung vom Modultyp nach Anspruch 7, dadurch gekennzeichnet, daß die erste Busschiene (801) aufwärts als eine Elektrode nach außen geführt ist;
eine zweite Busschiene (802) parallel zur und nahe an der ersten Busschiene (801) auf einer Seite davon angeordnet ist, und elektrisch mit dem Hauptstromausgangsanschluß (E) des einen (701-1) der Gehäuse verbunden ist; und
eine dritte Busschiene (803) parallel zu der und nahe bei der ersten Busschiene (801) auf der anderen Seite davon angeordnet ist und elektrisch mit dem Stromeingangsanschluß (C) des anderen (701-2) der Gehäuse verbunden ist.

## Revendications

1. Dispositif semi-conducteur de type module à haute puissance comprenant :

des premier et second boîtiers (401, 402) ;

des premier et second dispositifs semi-conducteurs de puissance (508) ayant des propriétés électriques équivalentes fermés hermétiquement respectivement dans lesdits premier et second boîtiers (401, 402) ; et

des bornes externes formées des bornes d'entrée de courant principal (C), des bornes de sortie de courant principal (E) et des bornes d'entrée de signaux (G, Es) desdits dispositifs semi-conducteurs de puissance placés sur une surface supérieure de chacun desdites premier et second boîtiers (401, 402) ;

lesdites bornes externes desdits premiers boîtiers ayant une disposition de borne dans laquelle les bornes d'entrée de signaux (G, Es) sont situées sur un côté opposé de la borne de sortie de courant principal (E) par rapport à ladite borne d'entrée de courant (C), et la borne externe dudit second boîtier ayant une disposition de borne dans laquelle les bornes d'entrée de signaux (G, Es) sont situées sur le côté opposé de la borne d'entrée de courant principal (C) par rapport à la borne de sortie de courant principal (E), de sorte que lesdits premier et second boîtiers (401, 401a, 402, 402a) sont formés sur un plan dans une paire de sorte que la borne d'entrée de courant principal (C) dudit premier boîtier (401, 401a) et la borne de sortie de courant principal (E) dudit second boîtier (402, 402a) sont à proximité immédiate et opposées l'une à l'autre, et qui de plus comprennent :

une première barre de bus (601) reliant électriquement lesdites borne d'entrée de courant en opposition (C) et borne de sortie de courant (E).

2. Dispositif semi-conducteur de type module selon la revendication 1, caractérisé en ce que lesdits premier et second boîtiers (401, 402) sont formés respectivement d'une résine.

3. Dispositif semi-conducteur de type module selon la revendication 1, caractérisé en ce que lesdits premier et second dispositifs semi-conducteurs de puissance (508) fermés hermétiquement dans lesdits premier et second boîtiers (401, 402) comprennent chacun des paires de puces semi-conductrices (506) ayant des propriétés électriques substantiellement équivalentes.

4. Dispositif semi-conducteur de type module selon la revendication 3, caractérisé en ce que lesdites puces semi-conductrices (506) ont une implantation pour lesdits dispositifs semi-conducteurs de puissance, qui est commune à la fois dans lesdits premier et second boîtiers (401, 402).

5. Dispositif semi-conducteur de type module selon la revendication 1, caractérisé en ce que lesdites bornes externes (E, C, G, Es) sont des bornes à vis.

6. Dispositif semi-conducteur de type module selon la revendication 1, caractérisé en ce que ladite première barre de bus est sortie à l'extérieur vers le haut comme une électrode, et dans lequel

une seconde barre de bus (602) située aussi parallèlement que possible et à proximité aussi proche que possible de ladite première barre de bus (601) sur un côté de celle-ci et électriquement reliée à la borne de sortie de courant (E) du dispositif semi-conducteur de puissance (508) qui est sortie à l'extérieur dudit premier boîtier (401, 401a) ; et

une troisième barre de bus (603) située aussi parallèlement que possible et à proximité aussi proche que possible de ladite première barre de bus (601) de l'autre côté de celle-ci et reliée électriquement à la borne d'entrée de courant (C) du dispositif semi-conducteur de puissance (508) qui est sortie à l'extérieur dudit second boîtier (402, 402a).

7. Dispositif semi-conducteur de type module à haute puissance comprenant :

des premier et second boîtiers ayant chacun une partie centrale en saillie sur une surface de dessus de celui-ci dont une surface est plane (701), ladite partie centrale en saillie étant adjointe sur des côtés opposés par deux plans de ladite surface supérieure à un niveau supérieur à ladite partie centrale, lesdits premier et second boîtiers comprenant chacun au moins une paire de puces semi-conductrices (506) pour former un dispositif semi-conducteur de puissance (508) enfermées hermétiquement à l'intérieur, chaque boîtier comprenant une borne d'entrée de courant principal (C) et une borne de sortie de courant principal (E) formées sur la partie centrale en saillie de celui-ci ; et

deux paires de bornes d'entrée de signaux reliées intérieurement, chaque paire (G, Es) étant située sur un des plans inférieurs positionnés sur les deux côtés de la partie centrale en saillie,

une desdites paires des bornes d'entrée de signaux (G, Es) dudit premier boîtier (701-1, 701-2) s'oppose à une desdites paires des bornes d'entrée de signaux (G, Es) dudit second boîtier, de sorte qu'une desdites bornes d'entrée de courant principal d'un desdits premier et second boîtiers s'oppose à une desdites bornes de sortie de courant principal de l'autre desdits premier et second boîtiers, et qui comprend en outre :

une première barre de bus (801) interconnectant électriquement lesdites borne d'entrée de courant en opposition (C) et borne de sortie de courant (E).

8. Dispositif semi-conducteur de type module selon la revendication 7, caractérisé en ce que ledit boîtier (701) est formé d'une résine.

9. Dispositif semi-conducteur de type module selon la revendication 7, caractérisé en ce que lesdites puces semi-conductrices (506) formant le dispositif semi-conducteur de puissance (508) enfermées hermétiquement à l'intérieur dudit boîtier sont deux ou plusieurs et ont des propriétés électriques équivalentes.

10. Dispositif semi-conducteur de type module selon la revendication 7, caractérisé en ce que la borne d'entrée de courant (C), la borne de sortie de courant (E) et les deux paires de bornes d'entrée de signaux (G, Es) sont, respectivement des bornes à vis.

11. Dispositif semi-conducteur de type module selon la revendication 7, caractérisé en ce que ladite première barre de bus (801) est sortie à l'extérieur vers le haut comme une électrode ;

une seconde barre de bus (802) est située parallèlement et à proximité immédiate de ladite première barre de bus (801) d'un côté de celle-ci et reliée électriquement à la borne de sortie de courant principal (E) dudit un (701-1) desdits boîtiers ; et

une troisième barre de bus (803) est située parallèlement et à proximité immédiate de ladite première barre de bus (801) sur l'autre côté de celle-ci et reliée électriquement à la borne d'entrée de courant (C) dudit autre (701-2) desdits boîtiers.

F I G. 1A

F I G. 1B

F I G. 1C

F I G.  2

F I G. 3A

F I G. 3B

F I G. 4A

F I G. 4B

F I G. 4C

F I G. 4D

F I G. 5

602 601 603

401a E_S G 402a
401 E_S G 402

F I G. 6A

601

602 603

401(401a) E_S G E C E C G E_S 402(402a)

F I G. 6B

F I G. 7A

F I G. 7B

F I G. 8